# EUROPÄISCHE PATENTSCHRIFT

(11) **EP 3 022 814 B1**
(45) Veröffentlichungstag und Bekanntmachung des Hinweises auf die Patenterteilung: **22.02.2017**
(21) Anmeldenummer: 14739192.4
(22) Anmeldetag: 16.07.2014
(51) Int. Cl.: H02H 3/17, H02H 9/02, H02H 3/33

(54) **VERFAHREN UND SCHALTUNGSANORDNUNG MIT MITTELN ZUR ABLEITSTROMKOMPENSATION IN EINER PHOTOVOLTAIKANLAGE MIT MEHREREN DIFFERENZSTROMSENSOREN**
METHOD AND CIRCUIT ARRANGEMENT WITH MEANS FOR A LEAKAGE CURRENT COMPENSATION IN A PHOTOVOLTAIC SYSTEM WITH MULTIPLE DIFFERENTIAL CURRENT SENSORS
PROCÉDÉ ET CIRCUITERIE POURVUE DE MOYENS DE COMPENSATION DE COURANT DE FUITE DANS UNE INSTALLATION PHOTOVOLTAÏQUE COMPRENANT PLUSIEURS CAPTEURS DE COURANT DIFFÉRENTIEL

(30) Priorität: 18.07.2013 DE 102013107689
(43) Veröffentlichungstag der Anmeldung: 25.05.2016
(73) Patentinhaber: SMA Solar Technology AG, 34266 Niestetal (DE)
(72) Erfinder: BIENIEK, Sebastian, 35066 Frankenberg (DE); HOPF, Markus, 34314 Espenau (DE)
(86) Internationale Anmeldenummer: PCT/EP2014/065252
(87) Internationale Veröffentlichungsnummer: WO 2015/007779

(56) Entgegenhaltungen:
- EP-A1- 2 372 857
- EP-A2- 1 291 997
- DE-A1-102011 051 954

## Beschreibung

### TECHNISCHES GEBIET DER ERFINDUNG

Die Erfindung bezieht sich auf ein Verfahren zur Ableitstromkompensation in einer Photovoltaikanlage mit den Schritten des Oberbegriffs des unabhängigen Patentanspruchs 1. Weiterhin bezieht sich die Erfindung auf eine Schaltungsanordnung zur Ableitstromkompensation in einer Photovoltaikanlage mit den Merkmalen des Oberbegriffs des unabhängigen Patentanspruchs 5. Zudem bezieht sich die Erfindung auf einen Photovoltaikwechselrichter mit den Merkmalen des Oberbegriffs des unabhängigen Patentanspruchs 9. Die Schaltungsanordnung und auch der Photovoltaikwechselrichter sind insbesondere zur Durchführung des erfindungsgemäßen Verfahrens vorgesehen. Dabei kann der Photovoltaikwechselrichter Teil der Schaltungsanordnung sein. Die Photovoltaikanlage umfasst neben der Schaltung und dem Photovoltaikwechselrichter mindestens einen Photovoltaikgenerator.

### STAND DER TECHNIK

Ein Verfahren mit den Schritten des Oberbegriffs des unabhängigen Patentanspruchs 1, eine Schaltungsanordnung mit den Merkmalen des Oberbegriffs des unabhängigen Patentanspruchs 5 und ein Photovoltaikwechselrichter mit den Merkmalen des Oberbegriffs des unabhängigen Patentanspruchs 9 sind aus der EP 2 372 857 A1 bekannt. Diese Druckschrift beschäftigt sich mit der Bestimmung des Fehlerstromanteils eines Differenzstroms, der als Stromsumme über den Strom eines Wechselstromgenerators führende Leitungen erfasst wird. Dazu wird ein elektrisches Signal von einem Referenzstrom generiert, den Spannungen an dem Wechselstromgenerator durch Kondensatoren nach Erde hervorrufen. Das elektrische Signal wird mit einem Skalierungsfaktor multipliziert, und das derart skalierte elektrische Signal wird als Maß für einen kapazitiven Ableitstromanteil von dem Differenzstrom subtrahiert. Dabei wird der Skalierungsfaktor fortlaufend in solcher Weise nachgeführt, dass der Effektivwert des Differenzstroms nach Subtraktion des skalierten elektrischen Signals minimiert ist. Die Subtraktion des skalierten elektrischen Signals von dem Differenzstrom kann mit dem den Differenzstrom erfassenden Summenstromwandler erfolgen. Bei dem durch Subtraktion des skalierten elektrischen Signals minimierten Effektivwert des Differenzstroms handelt es sich um den Effektivwert des Fehlerstroms, d. h. der von dem Summenstromwandler noch erfasste Differenzstrom ist der reine Fehlerstromanteil, der so selektiv überwacht werden kann.

Daneben sind Vorrichtungen zur Umwandlung einer eingangsseitig angelegten elektrischen Gleichspannung aus einem Photovoltaikgenerator in eine ausgangsseitige Wechselspannung, beispielsweise aus der DE 10 2011 051 954 A1, bekannt. Auch Systeme zur photovoltaischen Energieerzeugung mit einem Fehlerstromschutzschalter sind bekannt, beispielsweise aus der EP 1 291 997 A2.

Häufig ist es erforderlich, zusätzlich zu einer nach der Produktnorm EN 62109 geforderten RCMU (Residual Current Monitoring Unit) als Differenzstromsensor innerhalb eines elektrischen Geräts, wie bspw. eines Photovoltaikwechselrichters, eine oder mehrere externe RCD (Residual Current Protection Devices) als zusätzliche Differenzstromsensoren einzusetzen. Diese Fehlerstromschutzeinrichtungen überwachen einen Differenzstrom auf das Einhalten von Schwellwerten, messen ihn aber normalerweise nicht quantitativ. Auch wenn die aus der EP 2 372 857 A1 bekannte Kompensation des Ableitstromanteils an dem Differenzstrom innerhalb eines Photovoltaikwechselrichters durchgeführt wird, werden hierdurch Fehlauslösungen der externen RCD durch hohe Ableitstromanteile der von ihnen überwachten Differenzströme nicht verhindert.

Aus "ABB Technische Information, Fehlerstromschutzschaltung, unerwünschte Auslösungen von Fehlerstromschutzschaltern", Version 2010 5/C, ABB Schweiz AG ist es zur Überwachung einer zwischen einem Nullleiter und einem Polleiter angeschlossene Last mit großer Ableitkapazität bekannt, einen dreiphasigen Fehlerstromschutzschalter zu verwenden. Dabei wird ein Kompensationskondensator auf der der Last zugekehrten Seite des Summenstromwandlers zwischen den Anschluss des Polleiters und einen Anschluss eines ansonsten ungenutzten Strompfads durch den Summenstromwandler angeschlossen. Der eingangsseitige Anschluss dieses Strompfads wird außerhalb des Summenstromwandlers mit dem ausgangsseitigen Anschluss für den Nullleiter verbunden. Bei dieser Schaltungsanordnung fließt neben einem aus einem kapazitiven Ableitstrom von der Last resultierenden Differenzstrom ein zusätzlicher kapazitiver Ableitstrom über den Polleiter zu dem Kompensationskondensator. Dieser zusätzliche Ableitstrom fließt neben dem Polleiter zweimal in Gegenrichtung durch den Summenstromwandler, und zwar zum einen über den ansonsten ungenutzten Strompfad und zum anderen über den Nullleiter. Auf diese Weise wird ein Teil des von der Last abfließenden kapazitiven Ableitstroms kompensiert, d. h. von dem Summenstromwandler nicht erfasst. Für den Kompensationskondensator gelten Grenzen, damit im Falle einer abgeschalteten Last nicht der Ableitstrom über den Kompensationskondensator einen den Summenstromwandler aufweisenden Fehlerstromschutzschalter auslöst.

### AUFGABE DER ERFINDUNG

Der Erfindung liegt die Aufgabe zugrunde, auf einfache Weise die Robustheit der Absicherung einer Photovoltaikanlage durch weitere Fehlerstromschutzeinrichtungen, insbesondere solche ohne eigene Erfassung des tatsächlich fließenden Differenzstroms, trotz der stark schwankenden Ableitkapazitäten von Photovoltaikgeneratoren signifikant zu erhöhen.

### LÖSUNG

Die Aufgabe der Erfindung wird durch ein Verfahren mit den Schritten des unabhängigen Patentanspruchs 1, eine Schaltungsanordnung mit den Merkmalen des unabhängigen Patentanspruchs 5 und einen Photovoltaikwechselrichter mit den Merkmalen des unabhängigen Patentanspruchs 9 gelöst. Bevorzugte Ausführungsformen des Verfahrens, der Schaltungsanordnung und des Photovoltaikwechselrichters sind in den abhängigen Patentansprüchen definiert.

### BESCHREIBUNG DER ERFINDUNG

Wenn in dieser Beschreibung davon die Rede ist, dass ein Wert erfasst wird, so bedeutet dies, dass er quantitativ erfasst wird, d. h. hinsichtlich seiner aktuellen Größe. Diese Größe muss jedoch nicht genau bestimmt werden. Vielmehr reicht es beispielsweise aus, dass als Resultat der Erfassung des Werts ein Signal ausgegeben wird, das mit der aktuellen Größe des Werts steigt und fällt, wobei eine feste Beziehung zwischen der Amplitude des Signals und der Größe des Werts bevorzugt ist. Insoweit bedeutet das "Erfassen" eines Werts hier nicht zwingend, dass der Wert in irgendeiner physikalischen Einheit für den Wert gemessen wird.

Wenn in dieser Beschreibung ohne weitere Angaben von einem Differenzstromsensor die Rede ist, so kann dieser einen Differenzstrom überwachen und/oder erfassen. Selbst das Ausgeben eines Signals, das mit der aktuellen Größe des Werts steigt und fällt, ist für das Überwachen eines Differenzstroms mit einem Differenzstromsensor nicht zwingend. So kann der Differenzstrom auch nur derart überwacht werden, dass er mit einem oder mehreren Grenzwert(en) verglichen und ein Signal ausgegeben wird, wenn er einen der Grenzwerte überschreitet. Dieses Signal kann das Auslösen einer Fehlerstrom-Schutzvorrichtung sein. Ein Differenzstromsensor kann also grundsätzlich sowohl eine RCMU als auch eine RCD als auch von anderer Bauart sein. In der Regel wird er einen Summenstromwandler aufweisen.

Wenn in dieser Beschreibung von dem Minimieren einer Stromsumme die Rede ist, so bedeutet dies jedoch zumindest, dass ein Signal oder ein Wert, das/der mit der aktuellen Größe der Stromsumme steigt und fällt, minimiert wird. Insbesondere bedeutet das Minimieren der zeitlich variablen Stromsumme, dass ihr Effektivwert minimiert wird.

Wenn in dieser Beschreibung davon die Rede ist, dass ein Wechselstrom gegenüber einem anderen Wechselstrom eine durch einen negativen Faktor angepasste Amplitude aufweist, so bedeutet die Tatsache, dass der Faktor negativ ist, dass der eine Wechselstrom gegenphasig zu dem anderen Wechselstrom ist.

Unter einer stromführenden Leitung ist in dieser Beschreibung eine Leitung zu verstehen, die innerhalb einer Photovoltaikanlage zum Führen von Strom von einem Photovoltaikgenerator zum Ausgang der Photovoltaikanlage vorgesehen ist. Hierzu zählen auch Nullleiter. Nullleiter sind jedoch keine unter Spannung stehenden stromführenden Leitungen. Zu diesen zählen nur Pol- oder Phasenleiter auf der Wechselstromseite und die mit den Photovoltaikgeneratoren verbundenen Anschlussleitungen auf der Gleichstromseite, soweit sie nicht geerdet sind.

Bei einem erfindungsgemäßen Verfahren zur Ableitstromkompensation in einer Photovoltaikanlage wird ein von mindestens einer unter Spannung stehenden stromführenden Leitung über eine Kapazität nach Erde fließender Referenzstrom erfasst. Mit Phase und Frequenz des Referenzstroms und mit einer gegenüber dem Referenzstrom durch einen negativen Skalierungsfaktor angepassten Amplitude wird ein Kompensationsstrom generiert. Mit Hilfe eines Differenzstromsensors wird eine Stromsumme erfasst, wobei die Summanden der Stromsumme die Ströme durch einen vollständigen Satz von stromführenden Leitungen und der Kompensationsstrom sind. Durch Anpassen des Skalierungsfaktors wird die erfasste Stromsumme minimiert. Der Kompensationsstrom wird dann so durch mindestens einen anderen Differenzstromsensor geleitet, dass der Kompensationsstrom einen Ableitstromanteil an einem mit dem anderen Differenzstromsensor überwachten Differenzstrom kompensiert.

Dass die Stromsumme, die den Kompensationsstrom umfasst, mit Hilfe des einen Differenzstromsensors erfasst und erfindungsgemäß minimiert wird, bedeutet nicht, dass die gesamte Stromsumme von dem Differenzstromsensor, bspw. mit einem Summenstromwandler, erfasst werden muss. Der eine Differenzstromsensor kann auch nur eine Teilstromsumme über die Ströme durch den vollständigen Satz von stromführenden Leitungen bilden, wobei dann die Stromsumme, die auch den Kompensationsstrom enthält, an anderer Stelle gebildet wird, bspw. nach Digitalisierung sowohl der Teilstromsumme von dem Differenzstromsensor und als auch des Kompensationsstroms. Einfacher ist aber, wenn auch der Kompensationsstrom durch den Summenstromwandler des einen Differenzstromsensor geführt wird, so dass dieser direkt die gesamte Stromsumme erfasst.

Es ist anzumerken, dass der Kompensationsstrom auch in den Strömen enthalten sein kann, die durch den vollständigen Satz von stromführenden Leitungen fließen. Dies wird noch näher erläutert werden.

Unter einem vollständigen Satz von stromführenden Leitungen sind beispielsweise alle Leitungen zu verstehen, die den von der Photovoltaikanlage ausgegebenen Wechselstrom führen, einschließlich eines entsprechenden Nullleiters. Ein anderer vollständiger Satz von stromführenden Leitungen umfasst alle Eingangsleitungen, über die der oder die Photovoltaikgenerator(en) an einen Photovoltaikwechselrichter der Photovoltaikanlage angeschlossen ist/sind.

Bei der vorliegenden Erfindung wird ein Kompensationsstrom, wie er in der EP 2 372 857 A1 zur selektiven Erfassung des Fehlerstromanteils genutzt wird, um einen Ableitstromanteil eines mit einer RCMU erfassten Differenzstroms zu unterdrücken, zusätzlich zur Kompensation des Ableitstromanteils bei mindestens einem weiteren Differenzstromsensor genutzt. Dazu wird der Kompensationsstrom, der hinsichtlich des in ihm steckenden Skalierungsfaktors fortlaufend optimiert wird, durch den mindestens einen weiteren Differenzstromsensor hindurchgeleitet. Da durch den weiteren Differenzstromsensor, der denselben oder einen anderen vollständigen Satz von stromführenden Leitungen überwacht, grundsätzlich derselbe Differenzstrom fließen sollte, wird mit dem Kompensationsstrom auch dessen Ableitstromanteil bestmöglich kompensiert. Eine Auslöseschwelle des mindestens einen weiteren Differenzstromsensors kann so für eine hohe Sicherheit gegenüber Fehlerströmen relativ niedrig gesetzt werden, ohne dass eine unnötige Auslösung eines Schutzschalters durch den Differenzstromsensor erfolgt. Dies gilt auch bei sehr großen und schwankenden Ableitkapazitäten angeschlossener Photovoltaikgeneratoren, deren Auswirkungen durch den Kompensationsstrom in entsprechender Größe ausgeglichen werden. Auf diese Weise wird die Sicherheit der gesamten Photovoltaikanlage bestehend aus Photovoltaikgeneratoren, Photovoltaikwechselrichtern und externen Sicherungseinrichtungen erhöht und gleichzeitig die Wahrscheinlichkeit von Fehlauslösungen gesenkt, was wiederum insgesamt zu einem verlässlicheren Betrieb der Photovoltaikanlage beträgt.

Für die Durchführung des erfindungsgemäßen Verfahrens müssen alle weiteren Differenzstromsensoren nicht in der Lage sein, einen Wert oder auch nur ein Maß für den von Ihnen überwachten Differenzstrom auszugeben. Es kann sich bspw. um RCDs handeln.

Grundsätzlich kann bei der Durchführung des erfindungsgemäßen Verfahrens ein ansonsten ungenutzter Strompfad durch den mindestens einen anderen Differenzstromsensor genutzt werden, um auf diesem den Kompensationsstrom durch den mindestens einen anderen Differenzstromsensor zu leiten. Solche ungenutzten Strompfade stehen aber in der Regel nicht zur Verfügung, weil beispielsweise ein externer Differenzstromsensor für einen dreiphasigen Photovoltaikwechselrichter nur vier Strompfade aufweist, die von den drei Phasen und dem Nullleiter belegt sind. Anders mag es aussehen, wenn ein einphasiger Wechselrichter mit einem dreiphasigen Differenzstromsensor überwacht wird, weil dann grundsätzlich zwei Strompfade frei sind. In jedem Fall kann bei dem erfindungsgemäßen Verfahren der Kompensationsstrom auf dem Nullleiter durch den mindestens einen anderen Differenzstromsensor geleitet werden, so dass dafür kein zusätzlicher Strompfad benötigt wird. Im Falle eines auftretenden Differenzstroms fließt in der Regel sowieso ein Strom auch über den Nullleiter, der mit Hilfe des Kompensationsstroms tendenziell reduziert wird. Zudem fließt der Kompensationsstrom bei der Erfindung nur dann, wenn auch ein Ableitstrom auftritt.

Konkret kann der Kompensationsstrom durch eine Leiterschleife geführt werden, die sich durch alle Differenzstromsensoren erstreckt, bei denen der Ableitstromanteil an dem überwachten Differenzstrom kompensiert wird. Dazu kann die Schleife bis vor den am weitesten von dem Photovoltaikgenerator entfernt liegenden Differenzstromsensor vorlaufen und durch alle Differenzstromsensoren, bei denen der Ableitstromanteil an dem überwachten Differenzstrom kompensiert wird, zurücklaufen. Wenn die Leiterschleife den Nullleiter bzw. einen Abschnitt des Nullleiters einschließt, ist ihr darüber hinaus gehender Teil vor und hinter dem jeweils letzten Differenzstromsensor, bei dem der Ableitstromanteil an dem überwachten Differenzstrom kompensiert wird, an den Nullleiter anzuschließen.

Der Kompensationsstrom kann auch durch den einen Differenzstromsensor geführt werden, mit dessen Hilfe die Stromsumme erfasst wird, welche bei der Anpassung des Skalierungsfaktors minimiert wird. Dann wird die Stromsumme direkt in Form des von dem Differenzstromsensors erfassten Differenzstrom erfasst, und es reicht aus, das Ausgangssignal des einen Differenzstromsensors, das mit der in Form des Differenzstroms erfassten Stromsumme steigt und fällt, durch Anpassung des Skalierungsfaktors für den Referenzstrom zu minimieren.

Eine erfindungsgemäße Schaltungsanordnung zur Ableitstromkompensation in einer Photovoltaikanlage umfasst
- mindestens einen zwischen eine unter Spannung stehende stromführende Leitung und Erde geschalteten Kondensator,
- eine Stromerfassungseinrichtung zum Erfassen eines über den mindestens einen Kondensator nach Erde fließenden Referenzstroms,
- eine Stromquelle zum Generieren eines Kompensationsstroms mit Phase und Frequenz des Referenzstroms und mit einer gegenüber dem Referenzstrom durch einen negativen Skalierungsfaktor angepassten Amplitude,
- einen Differenzstromsensor umfassende Stromsummenerfassungseinrichtung zum Erfassen einer Stromsumme, wobei die Summanden der Stromsumme die Ströme durch einen vollständigen Satz von stromführenden Leitungen und - darin enthalten oder separat - der Kompensationsstrom sind,
- eine Logik zum Minimieren der erfassten Stromsumme durch Anpassen des Skalierungsfaktors und
- eine Leiterschleife zum Leiten des Kompensationsstroms durch mindestens einen anderen Differenzstromsensor, so dass der Kompensationsstrom einen Ableitstromanteil an einem mit dem anderen Differenzstromsensor überwachten Differenzstrom kompensiert.

Die Leiterschleife umfasst vorzugsweise einen Abschnitt eines Nullleiters durch den mindestens einen anderen Differenzstromsensor. Diese Leiterschleife wiederum erstreckt sich vorzugsweise durch mehrere Differenzstromsensoren. Zu diesen kann auch der Differenzstromsensor zählen, der zu den Stromsummenerfassungseinrichtungen zählt, so dass die Stromsummenerfassungseinrichtungen die Stromsummen in Form des von dem einen Differenzstromsensor erfassten Differenzstroms erfassen.

Ein erfindungsgemäßer Photovoltaikwechselrichter mit
- einem Eingang, an den ein Photovoltaikgenerator anschließbar ist,
- einem Ausgang zum Ausgeben eines Wechselstroms,
   einem Erdanschluss zum Anschließen an Erde,
- einem Differenzstromsensor, der einen Differenzstrom erfasst,
- mindestens einem zwischen eine unter Spannung stehende stromführende Leitung und den Erdanschluss geschalteten Kondensator,
- eine Stromerfassungseinrichtung zum Erfassen eines über den mindestens einen Kondensator zu dem Erdanschluss fließenden Referenzstroms,
- einer Stromquelle zum Generieren eines Kompensationsstroms mit Phase und Frequenz des Referenzstroms und mit einer gegenüber dem Referenzstrom durch einen negativen Skalierungsfaktor angepassten Amplitude,
- einer den Differenzstromsensor umfassenden Stromsummenerfassungseinrichtung zum Erfassen einer Stromsumme, wobei die Summanden der Stromsumme die Ströme durch einen vollständigen Satz von stromführenden Leitungen und - darin enthalten oder separat - der Kompensationsstrom sind; und
- einer Logik zum Minimieren der erfassten Stromsumme durch Anpassen des Skalierungsfaktors
ist erfindungsgemäß durch zwei Anschlüsse an dem Ausgang gekennzeichnet, zwischen denen, wenn sie elektrisch leitend miteinander verbunden sind, der von der Stromquelle generierte Kompensationsstrom fließt.

An diese Anschlüsse ist der extern des Photovoltaikwechselrichters verlaufende Teil einer Leiterschleife anschließbar, die den Kompensationsstrom durch alle Differenzstromsensoren führt, bei denen der Ableitstromanteil an dem überwachten Differenzstrom kompensiert werden soll.

Die beiden Anschlüsse an dem Ausgang für den Kompensationsstrom können einen Anschluss für einen Nullleiter des an dem Anschluss ausgegebenen Wechselstroms umfassen. Der andere Anschluss für den Kompensationsstrom kann der Erdanschluss des Photovoltaikwechselrichters oder ein dazu zusätzlicher Anschluss für eine sogenannte Funktionserde sein.

Wenn sich eine Leitung von der Stromquelle für den Kompensationsstrom zu einem der beiden Anschlüsse durch den Differenzstromsensor erstreckt, der zu den Stromsummenerfassungseinrichtungen gehört, erfassen die Stromsummenerfassungseinrichtungen die Stromsumme in Form des von dem Differenzstromsensor erfassten Differenzstroms. Das heißt, die Stromsumme wird unmittelbar durch den einen Differenzstromsensor gebildet.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten relativer Anordnungen und Wirkverbindungen mehrerer Bauteile - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: zeigt eine Photovoltaikanlage mit einer erfindungsgemäßen Schaltungsanordnung in einer ersten Ausführungsform.
- **Fig. 2**: zeigt eine Photovoltaikanlage mit einer erfindungsgemäßen Schaltungsanordnung in einer zweiten Ausführungsform.

### FIGURENBESCHREIBUNG

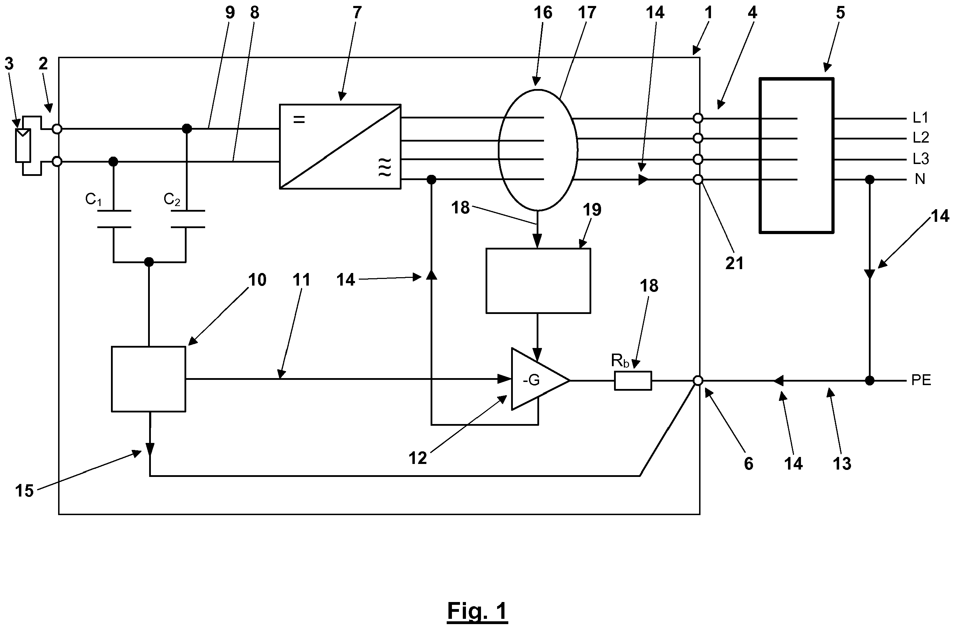

Bei der in **Fig. 1** gezeigten Photovoltaikanlage ist einen Photovoltaikwechselrichter 1 mit einem Eingang 2 an den ein Photovoltaikgenerator 3 angeschlossen. An einem Ausgang 4 des Photovoltaikwechselrichters 1 wird ein hier dreiphasiger Wechselstrom über Leitungen L1, L2, L3 und N ausgegeben, wobei für den N-Leiter ein Anschluss 21 vorgesehen ist. Alle stromführenden Leitungen L1, L2, L3 und N sind durch einen externen Differenzstromsensor 5 geführt, der den Photovoltaikwechselrichter 1 zusammen mit dem Photovoltaikgenerator 3 als Fehlerstrom-Schutzeinrichtung extern absichert. Konkret handelt es sich bei dem Differenzstromsensor 5 um eine Residual Current Protection Device (RCD). An seinem Ausgang 4 weist der Photovoltaikwechselrichter 1 einen zusätzlichen Anschluss 6 für Erde PE auf.

In dem Photovoltaikwechselrichter 1 ist zwischen dem Eingang 2 und dem Ausgang 4 ein DC/AC-Wandler 7 vorgesehen, der einen Eingangsgleichstrom von dem Photovoltaikgenerator 3 in den ausgegebenen Wechselstrom wandelt. Auf der DC-Seite des DC/AC-Wandlers 7 sind die beiden stromführenden Leitungen 8 und 9 jeweils über einen Kondensator C1 bzw. C2 mit dem Anschluss 6 und darüber mit Erde verbunden. Ein über diese Verbindung fließender Referenzstrom wird mit einer Stromerfassungseinrichtung 10 erfasst. Ein Ausgangssignal 11 der Stromerfassungseinrichtung 10 liegt an einem Steuereingang einer Stromquelle 12 an. Die Stromquelle 12 generiert einen Kompensationsstrom, der über einen negativen Skalierungsfaktor -G von dem Referenzstrom abhängt, der mit der Stromerfassungseinrichtung 10 erfasst wird. Dieser Kompensationsstrom fließt in einer Leiterschleife 13, wie durch Pfeilspitzen 14 angedeutet ist. Die Richtung der Pfeilspitzen 14 zeigt dabei die Gegenphasigkeit des Kompensationsstroms zu dem Referenzstrom an, dessen Richtung mit einer Pfeilspitze 15 angedeutet ist. Die Leiterschleife 13 umfasst einen Abschnitt des Nullleiters N auf der AC-Seite des DC/AC-Wandlers 7. Zwischen dem DC/AC-Wandler 7 und einem als RCMU ausgebildeten Differenzstromsensor 16 mit einem Summenstromwandler 17 zweigt die Leiterschleife 13 zu der Stromquelle 12 ab. Von der Stromquelle 12 erstreckt sie sich durch einen Begrenzungswiderstand R_{b} zu dem Anschluss 6, von dort über einen Abschnitt einer nach Erde PE führenden Leitung, die ausgangsseitig des Differenzstromwandlers 5 wieder mit dem Nullleiter N verbunden ist. Der Kompensationsstrom fließt so sowohl durch den externen Differenzstromsensor 5 als auch durch den Summenstromwandler 17 des Differenzstromsensors 16. Die von dem Summenstromwandler 17 erfasste Stromsumme 18 umfasst so auch den Kompensationsstrom. Eine Logik 19 wirkt abhängig vom Effektivwert der Stromsumme 18 auf die Stromquelle 12 durch Veränderung des Verstärkungsfaktors -G ein, um den Effektivwert der Stromsumme 18 zu minimieren. Die Stromsumme 18 erreicht aufgrund des zu dem Referenzstrom gegenphasigen Kompensationsstroms genau dann ein Minimum, wenn der Kompensationsstrom den Ableitstromanteil des mit dem Summenstromwandler 17 erfassten Differenzstrom vollständig kompensiert. Der Ableitstromanteil des Differenzstroms geht insbesondere auf Ableitkapazitäten des Photovoltaikgenerators 3 zurück, umfasst aber auch den über die Kondensatoren C1 und C2 fließenden Referenzstrom, wobei der gesamte Ableitstromanteil in Phase mit dem Referenzstrom ist. Indem der Kompensationsstrom über die Leiterschleife 13 auch durch den Differenzstromsensor 5 geführt wird, wird auch bei dem von diesem überwachten Differenzstrom der Ableitstrom bestmöglich kompensiert. Durch die fortlaufende Anpassung des Skalierungsfaktors -G folgt diese Kompensation den tatsächlichen aktuellen Ableitkapazitäten und den deshalb fließenden tatsächlichen Ableitströmen. So werden Fehlauslösungen des als RCD ausgebildeten Differenzstromsensors 5 vermieden, selbst wenn die RCD bezüglich des zulässigen Differenzstroms eng dimensioniert ist.

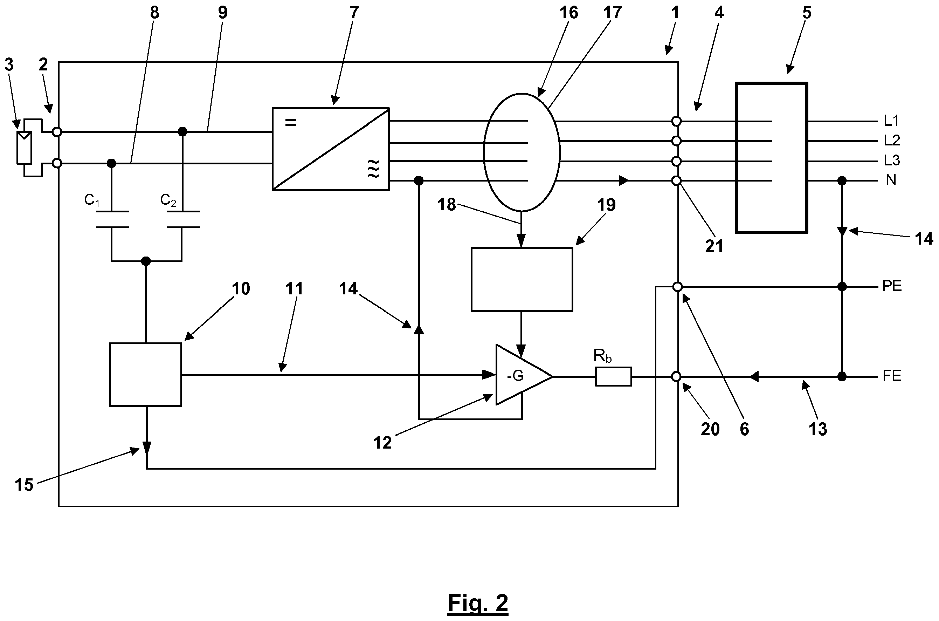

Bei der Ausführungsform der erfindungsgemäßen Schaltungsanordnung der Photovoltaikanlage gemäß **Fig. 2** und dem dazu zählenden Photovoltaikwechselrichter 1 bestehen folgende Unterschiede zu Fig. 1: Die Leiterschleife 13, durch die der Kompensationsstrom fließt, verläuft nicht über den Anschluss 6 für Erde PE, sondern über einen separaten Anschluss 20 des Ausgangs 4. Dieser Anschluss 20 ist für eine Funktionserde FE vorgesehen, die zwar ebenso wie der an den Anschluss 21 angeschlossene Nullleiter N mit Erde PE verbunden sein kann, aber nicht die eigentliche Erdung des Photovoltaikwechselrichters 1 bereitstellt. An der grundsätzlichen Funktion der Schaltungsanordnung in Bezug auf die Kompensation von kapazitiven Ableitströmen ändert sich hierdurch aber nichts. Diese Ausführungsform kann angezeigt sein, wenn Betriebsvorschriften existieren, die das Einleiten von Kompensationsströmen auf den Leitungen für Erde PE verbieten.

In beiden Fig. 1 und 2 sind zwei Kondensatoren C1 und C2 vorgesehen, die jeweils zwischen einer der Leitungen 8 und 9 und Erde PE geschaltet sind, um den kapazitiven Referenzstrom erfassen zu können. Der Referenzstrom ist aber auch erfassbar, wenn er nur von einer der unter Spannung stehenden Leitungen 8, 9 über den damit verbundenen Kondensator C1 oder C2 nach Erde PE fließt. Der Referenzstrom kann grundsätzlich auch über einen Kondensator geführt werden, der zwischen einen der Leiter L1, L2 und L3 und Erde PE geschaltet ist. Die Erde PE, zu der der Referenzstrom abfließt, kann überdies durch eine separate Erdung des Photovoltaikwechselrichters 1 bereitgestellt werden, die von dem Anschluss 6 unabhängig ist. Umgekehrt kann der Differenzstromsensor 16 mit dem Summenstromwandler 17 auch auf der DC-Seite des DC/AC-Wandlers 7 angeordnet sein.

### BEZUGSZEICHENLISTE

- 1: Photovoltaikwechselrichter
- 2: Eingang
- 3: Photovoltaikgenerator
- 4: Ausgang
- 5: Differenzstromsensor
- 6: Erdanschluss
- 7: DC/AC-Wandler
- 8: Leitung
- 9: Leitung
- 10: Stromerfassungseinrichtung
- 11: Signal
- 12: Stromquelle
- 13: Leiterschleife
- 14: Pfeilspitze
- 15: Pfeilspitze
- 16: Differenzstromsensor
- 17: Summenstromwandler
- 18: Stromsumme
- 19: Logik
- 20: Anschluss
- 21: Anschluss

## Patentansprüche

1. Verfahren zur Ableitstromkompensation in einer Photovoltaikanlage mit den Schritten:
- Erfassen eines von mindestens einer unter Spannung stehenden stromführenden Leitung (8, 9, L1, L2, L3) über eine Kapazität (C1, C2) nach Erde fließenden Referenzstroms;
- Generieren eines Kompensationsstroms mit Phase und Frequenz des Referenzstroms und mit einer gegenüber dem Referenzstrom durch einen negativen Skalierungsfaktor -G angepassten Amplitude;
- Erfassen einer Stromsumme (18) mit Hilfe eines Differenzstromsensors (16), wobei die Summanden der Stromsumme (18) die Ströme durch einen vollständigen Satz von stromführenden Leitungen (8, 9, L1, L2, L3, N) und - darin enthalten oder separat - der Kompensationsstrom ist;
- Minimieren der erfassten Stromsumme (18) durch Anpassen des Skalierungsfaktors -G;
**gekennzeichnet durch,**
- Leiten des Kompensationsstroms **durch** mindestens einen anderen Differenzstromsensor (5), so dass der Kompensationsstrom einen Ableitstromanteil an einem mit dem anderen Differenzstromsensor (5) überwachten Differenzstrom kompensiert.

2. Verfahren nach Anspruch 1, **dadurch gekennzeichnet, dass** der Kompensationsstrom auf einem Nullleiter (N) durch den mindestens einen anderen Differenzstromsensor (5) geleitet wird.

3. Verfahren nach Anspruch 1 oder 2, **dadurch gekennzeichnet, dass** der Kompensationsstrom durch eine Leiterschleife (13) geführt wird, die sich durch alle Differenzstromsensoren (5, 16) erstreckt, bei denen der Ableitstromanteil an dem überwachten Differenzstrom kompensiert wird.

4. Verfahren nach einem der vorhergehenden Ansprüche, **dadurch gekennzeichnet, dass** der Kompensationsstrom auch durch den einen Differenzstromsensor (16) geführt wird, um die Stromsumme in Form eines von dem einen Differenzstromsensor (16) erfassten Differenzstroms zu erfassen.

5. Schaltungsanordnung zur Ableitstromkompensation in einer Photovoltaikanlage, wobei die Schaltungsanordnung aufweist:
- mindestens einen zwischen eine unter Spannung stehende stromführende Leitung (8, 9, L1, L2, L3) und Erde (PE) geschalteten Kondensator (C1, C2);
- einer Stromerfassungseinrichtung (10) zum Erfassen eines über den mindestens einen Kondensator (C1, C2) nach Erde (PE) fließenden Referenzstroms;
- einer Stromquelle (12) zum Generieren eines Kompensationsstroms mit Phase und Frequenz des Referenzstroms und mit einer gegenüber dem Referenzstrom durch einen negativen Skalierungsfaktor -G angepassten Amplitude;
- einen Differenzstromsensor (16) umfassenden Stromsummenerfassungseinrichtungen zum Erfassen einer Stromsumme (18), wobei die Summanden der Stromsumme (18) die Ströme durch einen vollständigen Satz von stromführenden Leitungen (8, 9, L1, L2, L3, N) und
- darin enthalten oder separat - der Kompensationsstrom sind; und
- eine Logik (19) zum Minimieren der erfassten Stromsumme (18) durch Anpassen des Skalierungsfaktors -G;
**gekennzeichnet durch,**
- eine Leiterschleife (13) zum Leiten des Kompensationsstroms **durch** mindestens einen anderen Differenzstromsensor (5), so dass der Kompensationsstrom einen Ableitstromanteil an einem mit dem anderen Differenzstromsensor (5) überwachten Differenzstrom kompensiert.

6. Schaltungsanordnung nach Anspruch 5, **dadurch gekennzeichnet, dass** die Leiterschleife (13) einen Abschnitt eines Nulleiters (N) durch den mindestens einen anderen Differenzstromsensor (5) umfasst.

7. Schaltungsanordnung nach Anspruch 5 oder 6, **dadurch gekennzeichnet, dass** sich die Leiterschleife (13) durch mehrere Differenzstromsensoren (5, 16) erstreckt.

8. Schaltungsanordnung nach einem der Ansprüche 5 bis 7, **dadurch gekennzeichnet, dass** sich die Leiterschleife (13) durch den einen Differenzstromsensor (16) erstreckt, wobei die Stromsummenerfassungseinrichtungen die Stromsumme (18) in Form des von dem einen Differenzstromsensors (16) erfassten Differenzstroms erfassen.

9. Photovoltaikwechselrichter (1) mit
- einem Eingang (2), an den ein Photovoltaikgenerator (3) anschließbar ist;
- einem Ausgang (4) zum Ausgeben eines Wechselstroms;
- einem Erdanschluss (6) zum Anschließen an Erde;
**gekennzeichnet durch,**
- zwei Anschlüsse (6, 20; 21) an die eine Schaltungsanordnung zur Ableitstromkompensation nach Anspruch 5 angeschlossen ist und zwischen denen, wenn sie verbunden sind, der von der Stromquelle generierte Kompensationsstrom fließt.

10. Photovoltaikwechselrichter (1) nach Anspruch 9, **dadurch gekennzeichnet, dass** die beiden Anschlüsse (6, 20; 21) einen Anschluss (21) für einen Nullleiter (N) des ausgegebenen Wechselstroms umfassen.

11. Photovoltaikwechselrichter (1) nach Anspruch 9 oder 10, **dadurch gekennzeichnet, dass** die beiden Anschlüsse (6, 20; 21) an dem Ausgang (4) den Erdanschluss (6) oder einen dazu zusätzlichen Anschluss (20) für eine Funktionserde (FE) umfassen.

12. Photovoltaikwechselrichter (1) nach einem der Ansprüche 9 bis 11, **dadurch gekennzeichnet, dass** sich eine Leitung von der Stromquelle (12) zu einem der beiden Anschlüsse (6, 20; 21) durch den Differenzstromsensor (16) erstreckt, so dass die Stromsummenerfassungseinrichtungen die Stromsumme (18) in Form des von dem einen Differenzstromsensor (16) erfassten Differenzstroms erfassen.

## Claims

1. A method for leakage current compensation in a photovoltaic system, comprising the steps of:
- sensing a reference current flowing from at least one current-carrying line (8, 9, L1, L2, L3) under voltage via a capacitor (C1, C2) to earth;
- generating a compensation current, having the phase and frequency of the reference current, and having an amplitude adjusted by a negative scaling factor -G relative to the reference current;
- sensing a current sum (18) by means of a differential current sensor (16), the addends of the current sum (18) being the currents through a complete set of current-carrying lines (8, 9, L1, L2, L3, N) and - contained therein or separate - the compensation current;
- minimizing the sensed current (18) by adjusting the scaling factor -G;
**characterized by**
- routing the compensation current through at least one other differential current sensor (5), such that that the compensation current compensates a leakage current component of a differential current monitored by means of the other differential current sensor (5).

2. The method as claimed in claim 1, **characterized in that** the compensation current is routed on a neutral conductor (N) through the at least one other differential current sensor (5).

3. The method as claimed in claim 1 or 2, **characterized in that** the compensation current is carried through a conductor loop (13) that extends through all differential current sensors (5, 16) at which the leakage current component of the monitored differential current is compensated.

4. The method as claimed in any one of the preceding claims, **characterized in that** the compensation current is also carried through the one differential current sensor (16), in order to sense the current sum in the form of a differential current sensed by the one differential current sensor (16).

5. A circuit arrangement for leakage current compensation in a photovoltaic system, the circuit arrangement comprising:
- at least one capacitor (C1, C2) connected in circuit between a current-carrying line (8, 9, L1, L2, L3) under voltage and earth (PE);
- a current sensing means (10) for sensing a reference current flowing, via the at least one capacitor (C1, C2), to earth (PE);
- a current source (12) for generating a compensation current having the phase and frequency of the reference current, and having an amplitude adjusted by a negative scaling factor -G relative to the reference current;
- summated-current sensing means for sensing a current sum (18), comprising a differential current sensor (16), the addends of the current sum (18) being the currents through a complete set of current-carrying lines (8, 9, L1, L2, L3, N) and - contained therein or separate
- the compensation current; and
- a logic circuit (19) for minimizing the sensed current sum (18) by adjusting the scaling factor -G;
**characterized by**
- a conductor loop (13) for routing the compensation current through at least one other differential current sensor (5), such that the compensation current compensates a leakage current component of a differential current monitored by means of the other differential current sensor (5).

6. The circuit arrangement as claimed in claim 5, **characterized in that** the conductor loop (13) comprises a portion of a neutral conductor (N) through the at least one other differential current sensor (5).

7. The circuit arrangement as claimed in claim 5 or 6, **characterized in that** the conductor loop (13) extends through a plurality of differential current sensors (5, 16).

8. The circuit arrangement as claimed in any one of claims 5 to 7, **characterized in that** the conductor loop (13) extends through the one differential current sensor (16), the current sum sensing means sensing the current sum (18) in the form of the differential current sensed by the one differential current sensor (16).

9. A photovoltaic inverter (1), comprising
- an input (2)connectable to a photovoltaic generator (3);
- an output (4) for outputting an alternating current;
- an earth connection (6) for connecting to earth;
**characterized by**
two terminals (6, 20; 21) connected to a circuit arrangement for leakage current compensation as claimed in claim 5 between which , the compensation current generated by the current source flows. when they are electrically connected to each other.

10. The photovoltaic inverter (1) as claimed in claim 9, **characterized in that** the two terminals (6, 20; 21) comprise a connection (21) for a neutral conductor (N) of the output alternating current.

11. The photovoltaic inverter (1) as claimed in claim 9 or 10, **characterized in that** the two terminals (6, 20; 21) comprise, at the output (4), the earth connection (6) or a connection (20), additional thereto, for a functional earth (FE).

12. The photovoltaic inverter (1) as claimed in any one of claims 9 to 11, **characterized in that** a line extends from the current source (12) to one of the two terminals (6, 20; 21) through the differential current sensor (16), such that the current sum sensing means sense the current sum (18) in the form of the differential current sensed by the differential current sensor (16).

## Revendications

1. Procédé de compensation du courant de fuite dans une installation photovoltaïque, comprenant les étapes suivantes :
- détection d'un courant de référence qui circule vers la terre par le biais d'une capacité (C1, C2) depuis au moins une ligne (8, 9, L1, L2, L3) électriquement conductrice qui est sous tension ;
- génération d'un courant de compensation ayant la phase et la fréquence du courant de référence et ayant une amplitude adaptée par rapport au courant de référence par un facteur d'échelle négatif -G ;
- détection d'un courant total (18) à l'aide d'un capteur de courant différentiel (16), les opérandes de somme du courant total (18) étant les courants à travers un jeu complet de lignes (8, 9, L1, L2, L3, N) électriquement conductrices et le courant de compensation, contenu dans ceux-ci ou séparé ;
- réduction au minimum du courant total (18) détectée par adaptation du facteur d'échelle -G ;
**caractérisé par**
- conduite du courant de compensation à travers au moins un autre capteur de courant différentiel (5), de sorte que le courant de compensation compense une part de courant de fuite sur un courant différentiel surveillé avec l'autre capteur de courant différentiel (5).

2. Procédé selon la revendication 1, **caractérisé en ce que** le courant de compensation est conduit sur un conducteur neutre (N) à travers l'au moins un autre capteur de courant différentiel (5).

3. Procédé selon la revendication 1 ou 2, **caractérisé en ce que** le courant de compensation est acheminé à travers une boucle conductrice (13) qui s'étend à travers tous les capteurs de courant différentiel (5, 16), au niveau desquels la part de courant de fuite sur le courant différentiel surveillé est compensée.

4. Procédé selon l'une des revendications précédentes, **caractérisé en ce que** le courant de compensation est également acheminé à travers ledit capteur de courant différentiel (16) afin de détecter le courant total sous la forme d'un courant différentiel détecté par ledit capteur de courant différentiel (16).

5. Arrangement de circuit destiné à la compensation du courant de fuite dans une installation photovoltaïque, l'arrangement de circuit comprenant :
- au moins un condensateur (C1, C2) branché entre une ligne (8, 9, L1, L2, L3) électriquement conductrice qui est sous tension et la terre (PE) ;
- un dispositif de détection de courant (10) destiné à détecter un courant de référence qui circule vers la terre (PE) par le biais de l'au moins un condensateur (C1, C2) ;
- une source de courant (12) destinée à générer un courant de compensation ayant la phase et la fréquence du courant de référence et ayant une amplitude adaptée par rapport au courant de référence par un facteur d'échelle négatif -G ;
- des dispositifs de détection de courant total destinés à détecter un courant total (18) qui comprend un capteur de courant différentiel (16), les opérandes de somme du courant total (18) étant les courants à travers un jeu complet de lignes (8, 9, L1, L2, L3, N) électriquement conductrices et le courant de compensation, contenu dans ceux-ci ou séparé ; et
- un circuit logique (19) destiné à réduire au minimum le courant total (18) détecté par adaptation du facteur d'échelle -G ;
**caractérisé par**
- une boucle conductrice (13) destinée à conduire le courant de compensation à travers au moins un autre capteur de courant différentiel (5), de sorte que le courant de compensation compense une part de courant de fuite sur un courant différentiel surveillé avec l'autre capteur de courant différentiel (5).

6. Arrangement de circuit selon la revendication 5, **caractérisé en ce que** la boucle conductrice (13) comprend une portion d'un conducteur neutre (N) à travers l'au moins un autre capteur de courant différentiel (5).

7. Arrangement de circuit selon la revendication 5 ou 6, **caractérisé en ce que** la boucle conductrice (13) s'étend à travers plusieurs capteurs de courant différentiel (5, 16).

8. Arrangement de circuit selon l'une des revendications 5 à 7, **caractérisé en ce que** la boucle conductrice (13) s'étend à travers le capteur de courant différentiel (16), les dispositifs de détection de courant total détectant le courant total (18) sous la forme d'un courant différentiel détecté par ledit capteur de courant différentiel (16).

9. Onduleur photovoltaïque (1), comprenant
- une entrée (2) à laquelle peut être raccordé un générateur photovoltaïque (3),
- une sortie (4) servant à délivrer un courant alternatif ;
- une borne de terre (6) destinée au raccordement à la terre ;
**caractérisé par**
- deux bornes (6, 20 ; 21) auxquelles est raccordé un arrangement de circuit destiné à la compensation du courant de fuite selon la revendication 5 et entre lesquelles, lorsqu'elles sont reliées, circule le courant de compensation généré par la source de courant.

10. Onduleur photovoltaïque (1) selon la revendication 9, catactérisé en ce que les deux bornes (6, 20; 21) comprennent une borne (21) pour un conducteur neutre (N) du courant alternatif délivré.

11. Onduleur photovoltaïque (1) selon la revendication 9 ou 10, **caractérisé en ce que** les deux bornes (6, 20 ; 21) comprennent la borne de terre (6) à la sortie (4) ou une borne complémentaire (20) à celle-ci pour une terre fonctionnelle (FE).

12. Onduleur photovoltaïque (1) selon l'une des revendications 9 à 11, **caractérisé en ce qu'**une ligne s'étend de la source de courant (12) à l'une des deux bornes (6, 20 ; 21) à travers le capteur de courant différentiel (16), de sorte que les dispositifs de détection de courant total détectent le courant total (18) sous la forme du courant différentiel détecté par ledit capteur de courant différentiel (16).
